## Europäisches Patentamt
## European Patent Office
## Office européen des brevets

(19)

(11) Numéro de publication: **0 055 673**
**B1**

# FASCICULE DE BREVET EUROPEEN

(12)

(45) Date de publication du fascicule du brevet:
**12.09.84**

(51) Int. Cl.³: **H 03 K 17/08**

(21) Numéro de dépôt: **81402076.4**

(22) Date de dépôt: **24.12.81**

(54) **Appareil détecteur de proximite, respectivement de presence, du type à deux bornes alimenté en courant alternatif redressé sous une tension pouvant varier dans une large gamme avec commande de la charge à l'aide de thyristors de commutation.**

(30) Priorité: **31.12.80 FR 8027871**

(43) Date de publication de la demande:
**07.07.82 Bulletin 82/27**

(45) Mention de la délivrance du brevet:
**12.09.84 Bulletin 84/37**

(84) Etats contractants désignés:
**CH DE GB IT LI SE**

(56) Documents cités:
**DE - A - 2 750 992**
**DE - A - 2 845 553**
**FR - A - 2 234 711**
**FR - A - 2 348 605**
**FR - A - 2 445 075**
**FR - A - 2 457 604**
**GB - A - 2 023 360**

**ELEKTROTECHNISCHE ZEITSCHRIFT ETZ, édition B, vol. 24, no. 2, 28 jamvier 1972 Berlin, DE K. WETZEL: "Kurzschlussichere Endstufe", page 33**

(73) Titulaire: **LA TELEMECANIQUE ELECTRIQUE, 33 bis, avenue du Maréchal Joffre, F-92000 Nanterre (FR)**

(72) Inventeur: **Periot, Jean-Marie, 22, Lotissement la Ginotte, F-16400 La Couronne (FR)**

(74) Mandataire: **Marquer, Francis, CABINET MOUTARD 35, avenue Victor Hugo Résidence Champfleury, F-78180 Voisins le Bretonneux (FR)**

## Description

L'invention se rapporte aux appareils détecteurs de proximité, respectivement de présence, du type à deux bornes, alimentés en courant alternatif redressé et comportant un capteur associé à un circuit de commande, qui sont montés en série avec la charge à commander, et plus particulièrement aux appareils dont la tension d'alimentation peut varier dans une large gamme s'étendant par exemple d'environ 20 V à environ 240 V, et aux dispositifs d'alimentation, de commande du courant de sortie, et de protection contre les surcharges ou les courts-circuits que comportent de tels appareils.

A titre d'exemple, il s'agit de détecteurs à cellule photo-électrique, du type capacitif, ou autres.

Dans ces appareils, la commande de la charge est fréquemment réalisée en rendant conducteur au moins un thyristor lorsque le capteur délivre un signal de commande, ce qui provoque la circulation dans la charge, à travers le circuit, d'un courant, appelé courant de sortie, d'intensité suffisante pour commander la charge.

Ces appareils comportent généralement, en plus du capteur et du circuit de commande, des moyens de redressement du courant servant à l'alimentation de l'appareil, des résistances en série avec l'ensemble capteur-circuit de commande et qui servent à alimenter ce dernier lorsque la charge est au repos, et au moins une diode de Zener, connectée aux bornes de cet ensemble, et en série avec le thyristor afin de définir une tension de référence.

Un appareil du genre susvisé est notamment décrit dans le brevet FR-A N° 2457604 déposé par le titulaire le 25 mai 1979.

Dans ce type d'appareil, il importe de ne pas perturber le fonctionnement de la charge en réduisant la tension aux bornes de l'appareil lorsque la charge est commandée. La tension aux bornes de l'appareil, alors appelée tension de déchet, devra être la plus faible possible. En outre, ce genre d'appareil devant fonctionner sous des tensions d'alimentation très différentes (d'environ 20 V à environ 240 V par exemple), il est nécessaire de réguler le courant circulant dans le circuit, lorsque la charge est au repos, afin qu'il reste négligeable et sensiblement constant, quelle que soit la tension d'alimentation définie ci-dessus; ce courant est alors appelé courant résiduel.

Un inconvénient des appareils de l'art antérieur réside dans le fait que, lorsque le thyristor est rendu conducteur, la reprise de la commande de celui-ci ne peut se faire que lorsque le courant qui le traverse est voisin de zéro. Cela ne permet pas d'assurer la protection du montage lorsqu'une surcharge ou un court-circuit se produit alors qu'un ordre de commande de la charge est fourni par le capteur et que le thyristor est donc conducteur.

L'invention se propose de supprimer cet inconvénient en réalisant un appareil détecteur de proximité, respectivement de présence, du type à deux bornes comportant des moyens d'engendrer un signal de commande à partir de l'information fournie par un capteur, des moyens d'alimentation, connectés en série avec une charge à commander, fournissant un courant alternatif redressé sous une tension susceptible de varier dans une large gamme, et des moyens de commande de la charge, connectés aux moyens d'alimentation et aux moyens générateurs du signal de commande, les moyens de commande de la charge comportant au moins un thyristor et une diode de Zener, montés en série et en opposition, un transistor comportant une électrode d'entrée, une électrode de sortie et une électrode de commande, des moyens de relier la gâchette du thyristor à l'électrode d'entrée du transistor, des moyens de relier l'électrode d'entrée à la cathode de la diode de Zener, des moyens de relier l'électrode de sortie du transistor à l'anode de la diode de Zener, des moyens de connecter l'électrode de commande du transistor à la sortie desdits moyens d'engendrer un signal de commande, un condensateur, des moyens de relier le condensateur à la cathode de la diode de Zener, et des moyens de relier le condensateur à l'anode de la diode de Zener, le condensateur servant de source d'alimentation aux moyens d'engendrer le signal de commande lors des minima d'intensité du courant redressé traversant l'appareil, les moyens de commande de la charge comportant, en outre, des moyens de limiter l'intensité du courant circulant dans l'appareil, comprenant un composant semi-conducteur à fort gain monté en série avec le thyristor, et un amplificateur différentiel dont la sortie est connectée à l'électrode de commande du transistor, l'amplificateur différentiel et le composant semi-conducteur étant montés de manière telle que le transistor, normalement bloqué en présence d'un ordre de commande des moyens d'engendrer un signal de commande, se sature lors d'une surcharge ou d'un court-circuit, et bloque ainsi le thyristor.

On a déjà proposé, dans le brevet DE-A N° 2845553, un dispositif électronique de commutation dont l'organe de commande comporte des moyens de limiter l'intensité du courant comprenant un composant semi-conducteur monté en série avec un thyristor.

Pour obtenir un courant résiduel aussi faible que possible et sensiblement constant, tout en alimentant l'appareil sous une tension pouvant être choisie à l'intérieur d'une large gamme, l'invention propose d'utiliser un deuxième transistor, monté en série avec l'entrée de commande du composant semi-conducteur, et dont la base est d'une part reliée à la sortie de l'amplificateur différentiel, et d'autre part polarisée par l'intermédiaire d'un pont constitué d'une diode de Zener et d'une résistance.

Pour obtenir une tension de déchet aussi faible que possible, l'invention propose, par ailleurs, d'utiliser un second thyristor monté en série avec le composant semi-conducteur, et en parallèle sur le premier thyristor et la diode de Zener montés en série et en opposition.

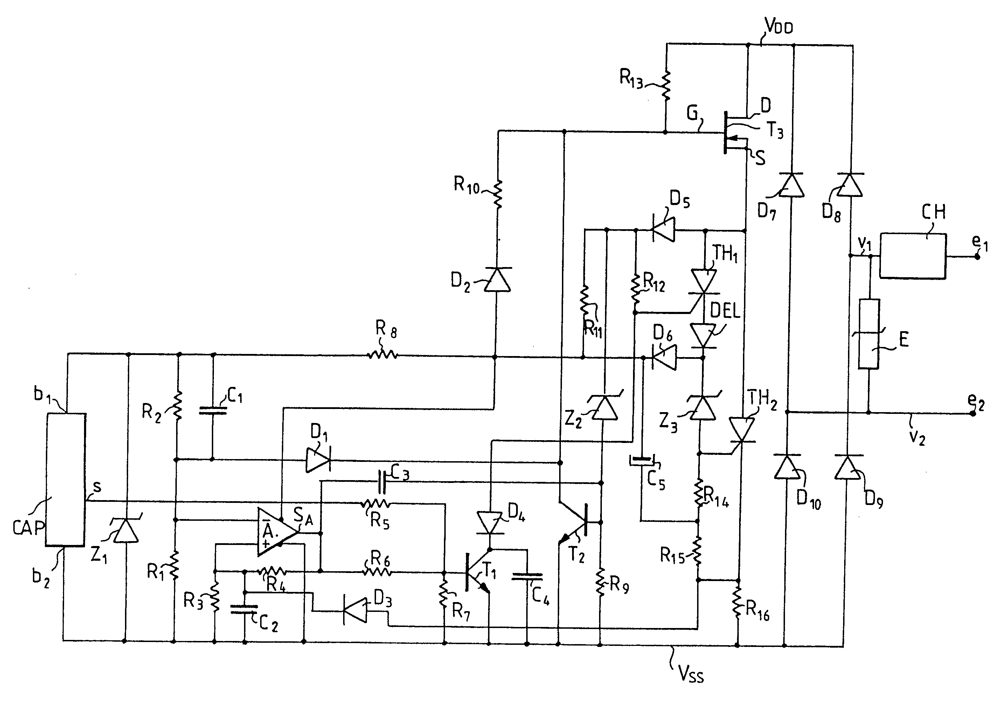

Les diverses particularités, ainsi que les avantages de l'invention, apparaîtront clairement à la lumière de la description ci-après, accompagnées de la figure unique du dessin annexé, qui représente le schéma d'un appareil du type à deux bornes conforme à un mode d'exécution préféré de l'invention.

Le montage, représenté à la figure jointe, est alimenté en tension alternative par l'intermédiaire de deux bornes d'alimentation, $e_1$ et $e_2$, reliées à un pont redresseur à double alternance à diodes, $D_7$-$D_{10}$, par deux conducteurs d'alimentation, respectivement $v_1$ et $v_2$, sur l'un desquels, $v_1$, est connectée en série une charge CH pouvant être par exemple un relais. Le pont redresseur $D_7$-$D_{10}$ fournit à ses bornes une tension redressée, alimentant le reste du montage par l'intermédiaire de deux conducteurs d'alimentation $V_{DD}$ (polarité positive) et $V_{SS}$ (polarité négative).

Un ensemble CAP capteur-circuit de commande de la charge comportant, par exemple, un phototransistor possède deux bornes d'alimentation, positive $b_1$ et négative $b_2$, et une sortie s. Il est alimenté par le pont de diodes par l'intermédiaire d'un transistor $T_3$, avantageusement du type MOS, dont le drain est directement connecté au conducteur $V_{DD}$, et dont la source est reliée à la borne positive $b_1$ de l'ensemble CAP à travers une diode $D_5$, une résistance $R_{11}$ et une résistance $R_{12}$, la borne $b_2$ étant directement reliée à $V_{SS}$. Le transistor $T_3$ est polarisé par l'intermédiaire d'une résistance $R_{13}$, montée entre la grille de $T_3$ et $V_{DD}$.

La grille de $T_3$ est reliée d'autre part à $V_{SS}$, par l'intermédiaire d'un transistor $T_2$, par exemple de type NPN, à travers sa jonction collecteur émetteur, l'émetteur étant relié à $V_{SS}$.

La source de $T_3$ est reliée à $V_{SS}$, par l'intermédiaire de $D_5$, à travers une diode de Zener $Z_2$ montée en opposition et une résistance $R_9$ montée en série avec $Z_2$, la base de $T_2$ étant connectée au circuit de jonction reliant l'anode de $Z_2$ à $R_9$. La source de $T_3$ est aussi reliée à $V_{SS}$, par l'intermédiaire d'un premier thyristor $TH_1$ dont la cathode est connectée à une diode électroluminescente DEL servant à signaler l'état au repos ou en charge de CH, en son anode, la cathode de DEL étant connectée à une diode de Zener $Z_3$, dont la tension de Zener est inférieure à celle de $Z_2$, montée en opposition et reliée à $V_{SS}$ par l'intermédiaire de trois résistances montées en série $R_{14}$, $R_{15}$, $R_{16}$, $R_{14}$ étant connectée à l'anode de $Z_3$ et $R_{16}$ à $V_{SS}$.

Un deuxième thyristor $TH_2$, monté en parallèle sur $TH_1$, DEL, $Z_3$, et les résistances $R_{14}$ et $R_{15}$ permet de relier la source de $T_3$ à $V_{SS}$ par l'intermédiaire de $R_{16}$. La gâchette $TH_2$ est connectée à l'anode de $Z_3$.

Une diode de Zener $Z_1$ est montée en parallèle sur les bornes $b_1$ et $b_2$, sa cathode étant reliée à $b_1$, et limite ainsi la tension pouvant être appliquée à l'ensemble CAP.

La sortie s polarise, au travers d'un pont de résistances $R_5$, $R_7$, $R_5$ étant connectée à s et $R_7$ à $V_{DD}$, la base d'un transistor $T_1$, par exemple du type NPN, dont l'émetteur est directement connecté à $V_{SS}$, et dont le collecteur est relié à $V_{DD}$ par l'intermédiaire et dans l'ordre où ils sont cités, à partir de $V_{DD}$, de $T_3$, de $D_5$, d'une résistance $R_{12}$ et d'une diode $D_4$ dont la cathode est reliée au collecteur de $T_1$. L'anode de $D_4$ est d'une part, comme énoncé ci-dessus, connectée à $R_{12}$, et d'autre part, connectée à la gâchette de $TH_1$. Le collecteur de $T_1$ est relié à $V_{SS}$ par l'intermédiaire d'un condensateur $C_4$.

Un condensateur $C_5$, servant de réservoir d'alimentation pour l'ensemble CAP, est connecté, d'une part, au point commun des résistances $R_{14}$ et $R_{15}$ et, d'autre part, à la borne $b_1$ de l'ensemble CAP par l'intermédiaire de $R_8$. Une diode $D_6$, dont l'anode est connectée à la cathode de DEL, et dont la cathode est reliée à une borne d'un condensateur $C_1$ par l'intermédiaire de $R_8$, permet la charge de $C_1$. Le condensateur $C_5$ est relié à la grille de $T_3$ par l'intermédiaire d'une diode $D_2$, montée en série avec une résistance $R_{10}$. Cette résistance $R_{10}$ relie la cathode de $D_2$ à la grille de $T_3$, et l'anode de $D_2$ est reliée à ladite borne de $C_1$ par l'intermédiaire de $R_8$.

Le montage comprend aussi un amplificateur opérationnel A comportant une borne d'alimentation positive reliée à $V_{DD}$ par l'intermédiaire de $R_{11}$, $D_5$, et de $T_3$, et une borne d'alimentation négative directement connectée à $V_{SS}$. Cet amplificateur opérationnel A comporte aussi deux entrées respectivement « + » et « − », et une sortie $S_A$.

L'entrée « − » de A est reliée à un pont de résistances $R_2$, $R_1$, monté en parallèle sur les bornes $b_1$, $b_2$ de l'ensemble CAP, la résistance $R_2$ étant connectée à $b_1$, et la résistance $R_1$ étant connectée à $b_2$, donc à $V_{SS}$. L'entrée « + » de A est, d'une part, reliée à $V_{SS}$ par l'intermédiaire d'une résistance $R_3$ et, d'autre part, à la sortie $S_A$ de A par l'intermédiaire d'une résistance $R_4$. La sortie $S_A$ est elle-même reliée à la base de $T_1$ par l'intermédiaire d'une résistance $R_6$, et à la base de $T_2$ par l'intermédiaire d'un condensateur $C_3$. Une diode $D_3$ permet d'assurer une liaison entre celle des bornes de la résistance $R_{16}$ qui n'est pas connectée à $V_{SS}$, et l'entrée « + » de A, la cathode de $D_3$ étant connectée à l'entrée « + », et étant aussi reliée à $V_{SS}$ par l'intermédiaire d'un condensateur $C_2$. Le condensateur $C_1$ est monté en parallèle sur $R_2$, et sa charge est assurée par l'intermédiaire d'une diode $D_1$ dont l'anode est connectée à la borne de $C_1$ reliée à l'entrée « − » de l'amplificateur A, et dont la cathode est connectée au collecteur de $T_2$.

Enfin, une résistance non linéaire E est montée entre les conducteurs $v_1$ et $v_2$ d'alimentation en courant alternatif en aval de la charge CH.

Lorsque la charge CH est au repos, c'est-à-dire lorsqu'aucun ordre de commande de la charge n'est détecté par le capteur de l'ensemble CAP, le transistor $T_3$ est polarisé par $R_{13}$ et est utilisé comme générateur de courant. Sa source est maintenue à un potentiel constant fixé par l'intermédiaire d'une diode de Zener $Z_2$ dont le courant de polarisation est limité par une résistance $R_9$ montée en série avec $Z_2$. L'intensité traversant $T_3$ est contrôlée par l'intermédiaire du transistor auxiliaire $T_2$, ce qui permet de maintenir un courant traversant la charge faible et minimum en présence d'une tension d'amplitude variable aux bornes $e_1$ et $e_2$, évitant ainsi que ce courant ne perturbe le fonctionnement de CH. Une partie du

courant engendré par $T_3$ sert à alimenter l'ensemble CAP dont la tension aux bornes est maintenue constante à l'aide de la diode de Zener $Z_1$. L'autre partie du courant engendré par $T_3$ traverse $T_1$, maintenu en son état saturé, la polarisation fournie à la sortie s étant appropriée à cet effet.

Lorsque le capteur de l'ensemble CAP reçoit un ordre de commande de la charge, cet ordre est transmis à la sortie s de l'ensemble CAP qui bloque $T_1$. Le courant fourni par $T_3$ charge alors le condensateur $C_4$, à travers $D_5$, $R_{12}$ et $D_4$, jusqu'à ce que la gâchette de $TH_1$ atteigne le potentiel nécessaire à l'amorçage de celui-ci. $TH_1$ devient alors conducteur, et charge à son tour $C_5$ jusqu'à ce que la différence de potentiel aux bornes de $C_5$ soit égale à la tension de Zener de $Z_3$, qui est inférieure à celle de $Z_2$. Une fois $C_5$ chargé, la diode de Zener $Z_3$ devient conductrice et le courant traversant $Z_2$ crée aux bornes des résistances $R_{14}$ et $R_{15}$ une différence de potentiel suffisante pour polariser la gâchette de $TH_2$ afin de le rendre conducteur. Ce dernier court-circuite alors $TH_1$, DEL et $Z_3$, ainsi que les résistances $R_{14}$ et $R_{15}$, réduisant ainsi la tension de déchet du montage à la chute de tension dans le pont de diodes, augmentée de celles dans $T_3$, $TH_2$ et $R_{16}$. Les valeurs des résistances $R_{14}$ et $R_{15}$ sont choisies de manière telle que l'élévation de potentiel aux bornes de $R_{15}$, due au courant de charge de $C_5$, n'est pas suffisante, dans des conditions normales de fonctionnement, pour polariser la gâchette de $TH_2$ de façon à le rendre conducteur, alors que l'élévation de potentiel aux bornes de $R_{14}$ et $R_{15}$ en série, lorsque $Z_3$ est passante, est suffisante pour rendre $TH_2$ conducteur. Cela explique que $TH_2$ ne s'amorcera que lorsque $Z_3$ sera passante.

Lorsque $TH_2$ est conducteur, la source de $T_3$ est sensiblement amenée au potentiel bas du circuit, la polarisation de grille de $T_3$ est alors fournie par le condensateur $C_5$, qui alimente la grille par l'intermédiaire de $D_2$ et $R_{10}$. La saturation de $T_3$ est ainsi assurée malgré la faible tension de déchet. Le condensateur $C_5$ sert aussi de réservoir d'alimentation en énergie pour l'ensemble CAP lorsque $TH_2$ est conducteur, la tension aux bornes du pont étant alors insuffisante. $R_{16}$ est traversée par un courant sensiblement égal à la totalité du courant traversant $T_3$, le courant dérivé par $R_8$ et l'ensemble CAP étant négligeable. La tension aux bornes de $R_{16}$ indique donc à chaque instant la valeur du courant traversant la charge. La différence de potentiel aux bornes de $R_{16}$ est appliquée, par l'intermédiaire de $D_3$, à l'entrée « + » de l'amplificateur opérationnel A.

En fonctionnement normal, c'est-à-dire en absence de surcharge, ce potentiel est inférieur à celui appliqué à la borne « − », par l'intermédiaire du pont de résistances $R_2$, $R_1$ et la sortie $S_A$ est sensiblement au potentiel bas du montage.

Lorsqu'une surcharge se produit, le courant traversant $T_3$ augmente, ce qui a pour effet d'accroître la différence de potentiel aux bornes de $R_{16}$, et par suite le potentiel de l'entrée « + ». Ce dernier devient alors supérieur à celui de l'entrée

« − », ce qui provoque la commutation de A. Une tension, égale à la tension d'alimentation de l'amplificateur différentiel, apparaît alors en $S_A$. Cette modification du potentiel de $S_A$ provoque le chargement de $C_3$ à travers $R_9$. Le courant de charge crée aux bornes de $R_9$ une différence de potentiel suffisante pour polariser la base de $T_2$, de sorte que celui-ci se sature, ce qui a pour effet d'amener la source de $T_3$ à un potentiel sensiblement égal au potentiel bas du circuit, et ainsi de bloquer $T_3$. $T_2$ est maintenu saturé tant que le courant de charge de $C_3$ crée une différence de potentiel suffisante aux bornes de $R_9$. Le blocage de $T_3$ entraîne celui de $TH_1$ et $TH_2$, aucun courant ne les traversant.

Bien qu'à cet instant la différence de potentiel aux bornes de $R_{16}$ soit nulle, la sortie de A est maintenue au niveau de la tension d'alimentation du circuit, car le potentiel de l'entrée « + » est maintenu supérieur à celui de l'entrée « − » par l'intermédiaire du pont de résistances $R_3$, $R_4$, les valeurs de $R_1$, $R_2$, $R_3$ et $R_4$ ayant été choisies à cet effet. D'autre part, le condensateur $C_1$ est chargé au moment du changement d'état de la sortie $S_A$ par l'intermédiaire de $T_2$ lorsque celui-ci est saturé. $C_1$ coopère ainsi au maintien du verrouillage de A lorsque celui-ci est assuré par le pont de résistances $R_3$, $R_4$ au moment du blocage de $TH_1$ et $TH_2$.

L'apparition d'une tension en $S_A$ a pour conséquence le passage de $T_1$ en son état saturé, la base de ce dernier étant reliée à $S_A$ à travers la résistance $R_6$. Le montage fonctionne alors comme décrit précédemment lorsqu'il n'y a pas d'émission d'ordre de commande. Le courant dans la charge se trouve finalement limité au courant circulant dans $T_1$ et dans l'ensemble CAP.

Pour remettre le circuit en fonctionnement, le déverrouillage de A sera obtenu, soit en débranchant un fil d'alimentation $v_1$ ou $v_2$ de l'appareil, soit en portant le potentiel de l'entrée « − » de A à un potentiel supérieur à celui de l'entrée « + ».

Le montage décrit ci-dessus réalise donc bien une protection de l'appareil en cas de surcharge ou court-circuit lorsque la charge est commandée, en réduisant le courant traversant le montage sensiblement au niveau du courant résiduel.

L'utilisation d'un transistor MOS permet de réaliser un circuit de commande ne consommant qu'un courant négligeable vis-à-vis de celui traversant la charge, et qui donc ne perturbe pas le fonctionnement de cette dernière. En effet, le courant de grille nécessaire pour commander le transistor MOS est de l'ordre de la centaine de nanoampères (100 à 200 nA), alors que le courant traversant le canal du transistor peut atteindre des intensités de l'ordre de l'ampère. Une autre propriété des transistors MOS est de pouvoir supporter à leurs bornes des tensions pouvant atteindre plusieurs centaines de volts. Cette propriété permet d'utiliser un transistor de ce genre dans des circuits dont la tension d'alimentation peut varier dans des plages importantes (d'environ 20 $V_{eff}$ à environ 240 $V_{eff}$ par exemple). Dans le dispositif selon l'invention, les deux propriétés décrites ci-dessus ont été utilisées. En effet, le transistor de technologie MOS sert de source de courant sous tension variable, en fonctionnement normal, et coopère à la protection du circuit en cas de surcharge ou court-circuit, tout en ne consommant qu'un très faible courant pour sa commande. Le dispositif réalisé ne consomme donc pour la partie commande qu'une faible énergie, ce qui est un des buts recherchés dans ce genre de circuit.

Lorsque l'ordre de commande émis par le capteur de l'ensemble CAP amorce le thyristor $TH_1$ en présence d'un court-circuit de charge, la diode DEL et le condensateur $C_5$ pourraient être détruits si la protection pour l'ensemble du montage était réglée pour fonctionner pour des courants supérieurs à ceux admissibles pour ces deux composants. Afin d'éviter cette destruction, la valeur de la résistance $R_{15}$ est choisie pour que la différence de potentiel à ses bornes soit suffisamment élevée pour provoquer l'amorçage de $TH_2$ lorsqu'elle est traversée par un courant dont la valeur est proche de la limite admissible par les deux composants $C_5$ et DEL, $TH_2$ dérivant le courant comme décrit précédemment.

La résistance non linéaire E permet la protection de l'appareil contre les surtensions d'origine selfique, pouvant apparaître aux bornes de la charge CH, lors du blocage du transistor $T_3$, lorsque celle-ci comporte des inductances.

Le montage décrit ci-dessus réalise donc bien un appareil à deux bornes dont la tension de déchet est faible en fonctionnement normal, grâce à la mise en service d'un deuxième thyristor, et étant protégé contre les surcharges et les courts-circuits, grâce au contrôle de l'intensité du courant traversant les thyristors par l'intermédiaire de l'amplificateur différentiel associé au transistor du type MOS. Ce montage présente aussi l'avantage de protéger les composants de montage pour lesquels le courant admissible est inférieur à celui pour lequel la protection est conçue, en cas d'amorçage sur un court-circuit de charge, par la mise en service du deuxième thyristor, ce qui a pour effet de dériver le courant qui aurait pu les détruire à travers ce dernier. Enfin, l'utilisation de $T_3$ comme source de courant permet à l'appareil de fonctionner sur une plage de tension pouvant aller par exemple de 20 à 240 V alternatif, le courant d'alimentation des circuits internes de l'appareil fourni par $T_3$ étant constant et indépendant de cette tension.

Il va de soi que le montage décrit pourra faire l'objet de variantes d'exécution sans s'écarter de l'invention : par exemple, le transistor de technologie MOS pourra être remplacé par un montage de Darlington de puissance à fort gain; le gain de celui-ci étant cependant inférieur à celui du transistor du type MOS, le courant nécessaire à sa commande sera plus important.

## Revendications

1. Appareil détecteur de proximité, respectivement de présence, du type à deux bornes comportant des moyens d'engendrer un signal de commande (CAP) à partir de l'information fournie par un capteur, des moyens d'alimentation ($e_1, e_2, v_1, v_2, D_7$-$D_{10}$), connectés en série avec une charge (CH) à commander, fournissant un courant alternatif redressé sous une tension susceptible de varier dans une large gamme, et des moyens de commande de la charge, connectés auxdits moyens d'alimentation et auxdits moyens générateur du signal de commande, lesdits moyens de commande de la charge comportant au moins un thyristor ($TH_1$) et une diode de Zener ($Z_3$), montés en série et en opposition, un transistor ($T_1$) comportant une électrode d'entrée, une électrode de sortie et une électrode de commande, des moyens ($D_4$) de relier la gâchette dudit thyristor ($TH_1$) à l'électrode d'entrée dudit transistor ($T_1$), des moyens ($D_4, R_{12}, D_5, TH_1$, DEL) de relier ladite électrode d'entrée à la cathode de ladite diode de Zener ($Z_3$), des moyens ($R_{14}, R_{15}, R_{16}$) de relier l'électrode de sortie dudit transistor à l'anode de ladite diode de Zener, des moyens ($R_6, R_7$) de connecter l'électrode de commande dudit transistor à la sortie (s) desdits moyens (CAP) d'engendrer ledit signal de commande, un condensateur ($C_5$), des moyens ($D_6$) de relier ledit condensateur à la cathode de ladite diode de Zener ($Z_3$), et des moyens ($R_{14}$) de relier ledit condensateur ($C_5$) à l'anode de ladite diode de Zener ($Z_3$), ledit condensateur servant de source d'alimentation auxdits moyens (CAP) d'engendrer le signal de commande lors des minima d'intensité du courant redressé traversant l'appareil, caractérisé en ce que lesdits moyens de commande de la charge comportent des moyens de limiter l'intensité du courant circulant dans l'appareil comprenant un composant semi-conducteur ($T_3$) à fort gain, monté en série avec ledit thyristor, et un amplificateur différentiel (A) dont la sortie ($S_A$) est connectée à l'électrode de commande dudit transistor ($T_1$), lesdits amplificateur différentiel et composant semi-conducteur ($T_3$) étant montés de manière telle que ledit transistor ($T_1$), normalement bloqué en présence d'un ordre de commande (1), se sature lors d'une surcharge ou d'un court-circuit et bloque ainsi ledit thyristor.

2. Appareil détecteur du type à deux bornes selon la revendication 1, caractérisé en ce que les bornes « + » et « − » de l'amplificateur différentiel (A) sont polarisées respectivement par l'intermédiaire d'un premier ($R_3, R_4$) et d'un deuxième ($R_1, R_2$) pont de résistances, la borne « + » étant en outre connectée à une première résistance ($R_{16}$), montée en série en aval de la diode de Zener ($Z_3$), et une ($R_4$) des résistances dudit premier pont de résistances étant connectée à la sortie ($S_A$) de l'amplificateur différentiel, les valeurs des différentes résistances étant choisies de manière telle que la sortie de l'amplificateur (A) soit à un niveau de potentiel bas en fonctionnement normal, et passe à un niveau de potentiel haut lors d'une surcharge ou d'un court-circuit, provoquant ainsi la saturation dudit transistor.

3. Appareil détecteur du type à deux bornes selon la revendication 2, caractérisé en ce qu'un deuxième condensateur ($C_1$) est monté en paral-

lèle sur une résistance ($R_2$) dudit premier pont de résistance, ladite résistance ($R_2$) étant connectée entre la borne « – » de l'amplificateur (A) et la borne d'alimentation positive ($b_1$) desdits moyens d'engendrer un signal de commande (CAP), ledit condensateur ($C_1$) coopérant au verrouillage de l'amplificateur différentiel (A) pour le maintien de la sortie ($S_A$) de l'amplificateur différentiel à un niveau de potentiel haut après une surcharge ou un court-circuit.

4. Appareil détecteur du type à deux bornes selon l'une quelconque des revendications 1 à 3, caractérisé en ce qu'il comporte un deuxième transistor ($T_2$) monté en série avec l'entrée de commande (G) du composant semi-conducteur ($T_3$) et dont la base est connectée à l'amplificateur différentiel (A) de manière telle que ledit deuxième transistor ($T_2$), normalement non saturé, se sature lorsqu'une surcharge ou un court-circuit de charge se produit, et que la saturation dudit transistor provoque le blocage du composant semi-conducteur ($T_3$) et coopère ainsi au blocage dudit thyristor ($TH_1$).

5. Appareil détecteur du type à deux bornes selon la revendication 4, caractérisé en ce que la base dudit deuxième transistor ($T_2$) est en outre polarisée par l'intermédiaire d'un pont constitué d'une diode de Zener ($Z_2$) et d'une résistance ($R_9$), ladite diode de Zener ($Z_2$) étant connectée à la sortie de puissance du composant semi-conducteur ($T_3$), de manière telle que le courant traversant le composant semi-conducteur ($T_3$) reste sensiblement inférieur ou égal à une valeur donnée lorsqu'aucun ordre de commande n'est émis, indépendamment de la valeur de ladite tension alternative d'alimentation.

6. Appareil détecteur du type à deux bornes selon l'une quelconque des revendications 1 à 5, caractérisé en ce qu'il comporte des secondes résistances ($R_{14}$, $R_{15}$) connectées en série entre ladite diode de Zener ($Z_3$) et ladite première résistance ($R_{16}$) et un deuxième thyristor ($TH_2$) monté en série avec le composant semi-conducteur, et en parallèle sur le thyristor ($TH_1$), la diode de Zener ($Z_3$) et lesdites secondes résistances ($R_{14}$, $R_{15}$) de manière telle que ledit deuxième thyristor ($TH_2$) dérive sensiblement la totalité du courant circulant dans le montage et réduise ainsi la tension de déchet due audit montage, la gâchette dudit deuxième thyristor ($TH_2$) étant connectée au point commun desdites deuxièmes résistances ($R_{14}$, $R_{15}$) et de la diode de Zener ($Z_3$).

7. Appareil détecteur du type à deux bornes selon la revendication 6, caractérisé en ce que le condensateur ($C_5$) pouvant servir de source d'alimentation aux moyens d'engendrer un signal de commande (CAP) est monté en série avec une diode ($D_2$), et est connecté entre l'entrée de commande (G) du composant semi-conducteur ($T_3$) et les moyens de redressement ($D_7$-$D_{10}$) de manière telle qu'il assure la polarisation de ladite entrée de commande (G) lorsque le deuxième thyristor ($TH_2$) est passant et maintient ainsi le composant semi-conducteur ($T_3$) dans son état saturé.

8. Appareil détecteur du type à deux bornes selon la revendication 7, caractérisé en ce que lesdites secondes résistances ($R_{14}$, $R_{15}$) sont composées d'au moins deux résistances ($R_{14}$, $R_{15}$) montées en série et que le condensateur ($C_5$) pouvant servir de source d'alimentation est relié au point commun desdites secondes résistances ($R_{14}$, $R_{15}$), les valeurs desdites secondes résistances étant telles que la polarisation du second thyristor ($TH_2$) ne se produise, lors de la charge dudit condensateur ($C_5$), que lorsque le courant de charge dépasse un certain seuil.

9. Appareil détecteur du type à deux bornes selon l'une quelconque des revendications 1 à 7, caractérisé en ce que le composant semi-conduc- teur ($T_3$) est un transistor du type MOS.

10. Appareil détecteur du type à deux bornes selon l'une quelconque des revendications 1 à 7, caractérisé en ce que le composant semi-conduc- teur ($T_3$) est du type montage de Darlington.


**Patentansprüche**

1. Annäherungs-, bzw. Anwesenheitsdetektorgerät des Zweiklemmentyps mit Mitteln, um ein auf den vom Sensor übermittelten Informationen basierendes Steuersignal (CAP) hervorzubringen, Speisungsvorrichtungen ($e_1$, $e_2$, $v_1$, $v_2$, $D_7$-$D_{10}$), die in Reihe an eine zu steuernde Last (CH) angeschlossen sind und einen, bei einer über einen grossen Bereich schwankenden Spannung, gleichgerichten Wechselstrom liefern, und Mittel zur Steuerung der Last, die an besagte Speivorrichtungen und Mittel zur Hervorbringung des Steuersignals angeschlossen sind, wobei die besagten Mittel zur Laststeuerung mindestens einen Thyristor ($TH_1$) und eine Zenerdiode ($Z_3$) aufwei- sen, die in Reihe und in Opposition geschaltet sind, sowie einen Transistor ($T_1$) mit einer Ein- gangselektrode, einer Ausgangselektrode und ei- ner Steuerelektrode, Mittel ($D_4$), das Gate des be- sagten Thyristors ($TH_1$) an die Eingangselektrode des besagten Transistors ($T_1$) anzuschliessen, Mittel ($D_4$, $R_{12}$, $D_5$, $TH_1$, DEL), um besagte Ein- gangselektrode an die Kathode der besagten Ze- nerdiode ($Z_3$) anzuschliessen, Mittel ($R_{14}$, $R_{15}$, $R_{16}$), um die Ausgangselektrode des besagten Transistors an die Anode der besagten Zenerdiode anzuschliessen, Mittel ($R_5$, $R_7$), um die Steuer- elektrode besagten Transistors an den Ausgang(s) der Mittel (CAP) zur Hervorbringung besagten Steuersignals anzuschliessen, einen Kondensator ($C_5$), Mittel ($D_6$), um besagten Kondensator an die Kathode besagter Zenerdiode ($Z_3$) anzu- schliessen, und Mittel ($R_{14}$), um besagten Kon- densator ($C_5$) an die Anode besagter Zenerdiode ($Z_3$) anzuschliessen, wobei besagter Kondensa- tor, wenn gleichgerichteter Strom minimaler Intensität durch das Gerät fliesst, als Speisequelle für besagte Mittel (CAP) zur Hervorbringung des Steuersignals dient, dadurch gekennzeichnet, dass besagte Mittel zur Steuerung der Last Mittel zur Intensitätsbegrenzung des im Gerät fliessenden Stroms enthalten, die eine Hochleistungs-

Halbleiterkomponente ($T_3$) einschliessen, der in Reihe an besagten Thyristor angeschlossen ist, sowie einen Differentialverstärker (A), dessen Ausgang ($S_A$) an die Steuerelektrode besagten Transistors ($T_1$) angeschlossen ist, wobei der besagte Differentialverstärker und die besagte Halbleiterkomponente ($T_3$) so geschaltet sind, dass besagter Transistor ($T_1$), der beim Vorhandensein eines Steuerbefehls der Mittel zur Hervorbringung dieses Befehls normalerweise blockiert ist, bei Überlastung oder Kurzschluss gesättigt wird und so besagten Thyristor blockiert.

2. Detektorgerät des Zweiklemmentyps, gemäss Patentanspruch 1, dadurch gekennzeichnet, dass die «+» und «−» Klemmen des Differentialverstärkers (A) jeweils durch eine erste ($R_3$, $R_4$) und eine zweite ($R_1$, $R_2$) Widerstandsbrücke polarisiert werden, wobei die «+» Klemme ausserdem an einen unterhalb der Zenerdiode ($Z_3$) in Reihe geschalteten ersten Widerstand ($R_{16}$) angeschlossen ist und wobei einer der Widerstände ($R_4$) der besagten Widerstandsbrücke an den Ausgang ($S_A$) des Differentialverstärkers angeschlossen ist. Der Wert der verschiedenen Widerstände ist so gewählt, dass der Ausgang des Verstärkers (A) bei normalem Arbeitsgang ein niedriges Potentialniveau hat und bei Überlastung oder Kurzschluss auf ein hohes Potential übergeht und auf diese Weise die Sättigung des Transistors bewirkt.

3. Detektorgerät des Zweiklemmentyps, gemäss Patentanspruch 2, dadurch gekennzeichnet, dass ein zweiter Kondensator ($C_1$) mit einem Widerstand ($R_2$) der ersten Widerstandsbrücke parallelgeschaltet ist, wobei besagter Widerstand ($R_2$) zwischen die «−» Klemme des Verstärkers (A) und die positive Speiseklemme ($b_1$) besagter Mittel zur Hervorbringung eines Steuersignals (CAP) angeschlossen ist. Besagter Kondensator ($C_1$) wirkt mit an der Verriegelung des Differentialverstärkers (A), um dessen Ausgang ($S_A$) nach eine Überlastung oder einem Kurzschluss auf einem hohen Potentialniveau zu halten.

4. Detektorgerät des Zweiklemmentyps, gemäss einem der Ansprüche 1 bis 3, dadurch gekennzeichnet, dass es einen zweiten Transistor ($T_2$) enthält, der in Reihe an den Steuereingang (G) der Halbleiterkomponente ($T_3$) angeschlossen ist und dessen Basis so mit dem Differentialverstärker (A) verbunden ist, dass der zweite Transistor ($T_2$), der normalerweise nicht gesättigt ist, beim Auftreten einer Überlastung oder eines Kurzschlusses gesättigt wird und die Sättigung besagten Transistors die Blockierung der Halbleiterkomponente ($T_3$) bewirkt und so an der Blockierung besagten Thyristors ($TH_1$) mitwirkt.

5. Detektorgerät des Zweiklemmentyps, gemäss Anspruch 4, dadurch gekennzeichnet, dass die Basis besagten zweiten Transistors ($T_2$) ausserdem durch eine, aus einer Zenerdiode ($Z_2$) und einem Widerstand ($R_9$) bestehende Brücke polarisiert wird, wobei besagte Zenerdiode ($Z_2$) an den Leistungsausgang der Halbleiterkomponente ($T_3$) so angeschlossen ist, dass der durch die Halbleiterkomponente ($T_3$) fliessende Strom in etwa unter einem gegebenen Wert bleibt oder diesen erreicht, wenn kein Steuerbefehl erteilt wurde, unabhängig vom Wert der besagten Speise-Wechselspannung.

6. Detektorgerät des Zweiklemmentyps, gemäss einem der Ansprüche 1 bis 5, dadurch gekennzeichnet, dass es zweite Widerstände ($R_{14}$, $R_{15}$) enthält, die in Reihe zwischen besagte Zenerdiode ($Z_3$) und besagten Widerstand ($R_{16}$) geschaltet sind und einen zweiten Thyristor ($TH_2$), der so in Reihe mit der Halbleiterkomponente und parallel mit dem Thyristor ($TH_1$), der Zenerdiode ($Z_3$) und besagten zweiten Widerständen ($R_{14}$, $R_{15}$) geschaltet ist, dass besagter zweiter Thyristor ($TH_2$) etwa den gesamten im Schaltkreis fliessenden Strom ableitet und so die von besagter schaltung verursachte Offsetspannung verringert, wobei das Gate des besagten zweiten Transistors ($TH_2$) an den gemeinsamen Punkt der besagten zweiten Widerstände ($R_{14}$, $R_{15}$) und der Zenerdiode ($Z_3$) angeschlossen ist.

7. Detektorgerät des Zweiklemmentyps, gemäss Anspruch 6, dadurch gekennzeichnet, dass der Kondensator ($C_5$), der zur Speisung der Mittel zur Hervorbringung eines Steuersignals (CAP) dienen kann, in Reihe mit einer Diode ($D_2$) geschaltet ist und so zwischen den Steuereingang (G) der Halbleiterkomponente ($T_3$) und die Gleichrichtermittel ($D_7$-$D_{10}$) geschaltet ist, dass er die Polarisierung des besagten Steuereingangs (G) bewirkt, wenn der zweite Thyristor ($TH_2$) leitet und so die Halbleiterkomponente ($T_3$) im Sättigungszustand hält.

8. Detektorgerät des Zweiklemmentyps, gemäss Anspruch 7, dadurch gekennzeichnet, dass besagte zweite Widerstände ($R_{14}$, $R_{15}$) mindestens aus zwei reihengeschalteten Widerständen ($R_{14}$, $R_{15}$) bestehen und dass der Kondensator ($C_5$), der als Speisequelle dienen kann, an den gemeinsamen Punkt besagter zwei Widerstände ($R_{14}$, $R_{15}$) angeschlossen ist, wobei die Werte besagter zwei Widerstände so gewählt sind, dass die Polarisierung des zweiten Thyristors ($TH_2$) bei der Aufladung besagten Kondensators ($C_5$) nur dann stattfindet, wenn der Ladestrom eine gewisse Schwelle überschreitet.

9. Detektorgerät des Zweiklemmentyps, gemäss einem der Ansprüche 1 bis 7, dadurch gekennzeichnet, dass die Halbleiterkomponente ($T_3$) ein Transistor des MOS-Typs ist.

10. Detektorgerät des Zweiklemmentyps, gemäss einem der Ansprüche 1 bis 7, dadurch gekennzeichnet, dass die Halbleiterkomponente ($T_3$) eine vom Typ Darlingtonschaltung ist.

## Claims

1. Proximity, respectively presence detector apparatus of the two terminal type, comprising means for generating a control signal (CAP) from the data supplied by a sensor, supply means ($e_1$, $e_2$, $v_1$, $v_2$, $D_7$-$D_{10}$,) series-connected with a load (CH) to be controlled, supplying a rectified AC current under a voltage variable over a large scale and load control means, connected to said supply means and to said means for generating the control signal, said load control means comprising at least one thyristor ($TH_1$) and a Zener diode ($Z_3$), series and oppositely connected, a transistor ($T_1$) comprising an input electrode, an output electrode and a control electrode, means ($D_4$) for connecting the gate of said thyristor ($TH_1$) to the input electrode of said transistor ($T_1$), means ($D_4$, $R_{12}$, $D_5$; $TH_1$; DEL) for connecting said input electrode to the cathode of said Zener diode ($Z_3$), means ($R_{14}$, $R_{15}$, $R_{16}$) for connecting the output electrode of said transistor to the anode of said Zener diode, means ($R_5$, $R_7$) for connecting the control electrode of said transistor to the output (s) of said means (CAP) for generating said control signal, a capacitor ($C_5$), means ($D_6$) for connecting said capacitor to the cathode of said Zener diode ($Z_3$) and means ($R_{14}$) for connecting said capacitor ($C_5$) to the anode of said Zener diode ($Z_3$), said capacitor acting as a supply source for said means (CAP) for generating the control signal when minimum intensities of rectified current are flowing through the apparatus, wherein said load control means comprise means for limiting the intensity of the current flowing through the apparatus, said means comprising a semi-conductor high gain component ($T_3$) series connected with said thyristor, and a differential amplifier (A) whose output ($S_A$) is connected to the control electrode of said transistor ($T_1$), said differential amplifier and said semi-conductor component ($T_3$) being mounted in such a way that the said transistor ($T_1$), normally cut off in the presence of a control order of the means for generating such an order is saturated in the case of an overload or a short circuit and so cuts off the said thyristor.

2. Detector apparatus of the two terminal type, according to claim 1, wherein the « + » and « − » terminals of the differential amplifier (A) are respectively biassed by a first ($R_3$, $R_4$) and a second ($R_1$, $R_2$) resistor bridge, the « + » terminal being further connected to a first resistor ($R_{16}$) series-connected after the Zener diode ($Z_3$) and one ($R_4$) of the resistors of the said resistor bridge being connected to the output ($S_A$) of the differential amplifier, the values of the different resistors being chosen such that the amplifier output (A) is at a low potential level for normal operation and passes to a high potential lever in case of an overload or a short circuit, thus bringing about the saturation of said transistor.

3. A detector apparatus of the two terminal type according to claim 2, wherein a second capacitor ($C_1$) is mounted in parallel across a resistor ($R_2$) of the said first resistor bridge, said resistor ($R_2$) being connected between the « − » terminal of the amplifier (A) and the positive supply terminal ($b_1$) of said means for generating a control signal (CAP), said capacitor ($C_1$) cooperating for cutting off the differential amplifier (A) so as to maintain the output ($S_A$) of the differential amplifier at a high potential level after an overload or a short circuit.

4. A detector apparatus of the two terminal type according to anyone of claims 1 to 3, characterized in that it comprises a second transistor ($T_2$) series connected to the control input (G) of the semi-conductor component ($T_3$) and whose base is connected to the differential amplifier (A) in such a way that the said second transistor ($T_2$), normally not saturated, is saturated when an overload or a load short circuit occurs and that the saturation of the said transistor (b) locks the semi-conductor component ($T_3$) and thus cooperates in cutting off the said thyristor ($TH_1$).

5. A detector apparatus of the two terminal type according to claim 4, wherein the base of the said second transistor ($T_2$) is further biassed by a bridge formed of a Zener diode ($Z_2$) and a resistor ($R_9$), said Zener diode ($Z_2$) being connected to the power output of the semi-conductor component ($T_3$) in such a way that the current flowing through the semi-conductor component ($T_3$) remains substantially inferior or equal to a given value when no control order is issued, independently of the value of the said AC supply voltage.

6. A detector apparatus of the two terminal type, according to anyone of claims 1 to 5, characterized in that it comprises second resistors ($R_{14}$, $R_{15}$) series connected between said Zener diode ($Z_3$) and said first resistor ($R_{16}$) and a second thyristor ($TH_2$) mounted in series with the semi-conductor component and in parallel across thyristor ($TH_1$), the Zener diode ($Z_3$) and said second resistors ($R_{14}$, $R_{15}$) in such a way that the said second thyristor ($TH_2$) substantially shunts the totality of the current flowing in the circuit and thus reduces the offset voltage due to said circuit arrangement, the gate of said second thyristor ($TH_2$) being connected to the junction point of the said second resistors ($R_{14}$, $R_{15}$) and the Zener diode ($Z_3$).

7. A detector apparatus of the two terminal type according to claim 6, wherein the capacitor ($C_5$), adapted to act as a supply source for the means for generating a control signal (CAP) is mounted in series with a diode ($D_2$) and connected between the control input (G) of the semi-conductor component ($T_3$) and the rectifying means ($D_7$-$D_{10}$) so as to effect the biassing of said control input (G) when the second thyristor ($TH_2$) is conducting and thus to maintain the semi-conductor component ($T_3$) in its saturated state.

8. A detector apparatus of the two terminal type according to claim 7, wherein the said second resistors ($R_{14}$, $R_{15}$) comprise at least two resistors ($R_{14}$, $R_{15}$) mounted in series and the capacitor ($C_5$), adapted to act as a supply source, is connected to the junction point of the said second resistors ($R_{14}$, $R_{15}$), the values of said second resistors being such that biassing of the second thyristor ($TH_2$) only occurs, while loading the said capacitor ($C_5$), when the load current exceeds a certain threshold.

9. A detector apparatus of the two terminal type according to anyone of claims 1 to 7, wherein the

semi-conductor component ($T_3$) is a MOS type transistor.

10. A detector apparatus of the two terminal type according to either of claims 1 to 7, wherein the semi-conductor component is of the Darlington circuit type.